# DEMANDE DE BREVET EUROPEEN

(11) **EP 0 901 165 A1**
(43) Date de publication de la demande: **10.03.1999**
(21) Numéro de dépôt: 98402158.4
(22) Date de dépôt: 01.09.1998
(51) Int. Cl.: H01L 23/498, H01L 21/48

(54) **Boîtier à microcircuit intégré et procédé de montage de microcircuit intégré**

(30) Priorité: 05.09.1997 FR 9711074
(71) Demandeur: MATRA MARCONI SPACE FRANCE, 75116 Paris (FR)
(72) Inventeur: De Givry, Jacques, 78350 Les Loges en Josas (FR)
(74) Mandataire: Fort, Jacques

(57) **Abrégé**

Le boîtier comprend un microcircuit (10) présentant des plages de sortie (12) réparties à la périphérie d'une face active, et une plaquette adaptatrice dont une face est collée à la face active, laissant libres les plages de sortie (12), présentant à sa périphérie des plages d'accueil reliées chacune par une piste équipotentielle à une protubérance (32) en saillie sur la face opposée à la face collée.

Des fils métalliques (24) soudés relient les plages de sortie (12) aux plages d'accueil (18). Les protubérances font saillie à travers un enrobage étanche (34).

## Description

La présente invention concerne le domaine du montage des microcircuits intégrés monolithiques, couramment appelés puces, sur un substrat destiné à recevoir plusieurs microcircuits, souvent dénommés par le terme anglo-saxon "multichip module".

Il existe divers procédés de montage de microcircuits présentant des plages de sortie réparties à la périphérie d'une grande face. Ces procédés connus présentent des inconvénients. Le câblage direct des puces nues sur des substrats à l'aide de tronçons de fil libres est difficilement compatible avec la réalisation des tests de vieillissement. Le report direct automatique de circuits amenés sur une bande, dit "tape automated bonding" nécessite chez l'équipementier utilisateur de microcircuits un équipement important.

Pour faciliter le montage des microcircuits sans pour autant réduire notablement la densité d'implantation possible, on a proposé des boîtiers à microcircuit d'encombrement légèrement supérieur à celui du microcircuit, munis sur une grande face de billes de connexion. Le pas de ces billes est suffisant pour que les billes puissent être accueillies sur un circuit imprimé. Elles sont en matériau fusible, tel qu'un alliage étain plomb. Toutes les connections peuvent être simultanément effectuées par refusion en étuve.

On connaît (US-A-5 633785) un ensemble constitué d'un micro-circuit et d'un substrat d'interconnexion multicouches, formé d'un support et d'une carte multi-couches, typiquement cuivre-polyimide. Des fils métalliques relient des plages de sortie à des plages (bond pads) reliées par des pistes équipotentielles à des protubérances. Cet ensemble ne comporte pas d'enrobage traversé par des protubérances.

Le document JP 03-094438 A décrit une technique de constitution de contacts traversant un encapsulage de résine. On constitue des billes par fusion d'une extrêmité de fils, on enrobe puis on polit et on forme des bossettes.

La présente invention vise notamment à fournir un microcircuit équipé, qu'on qualifiera de boîtier à microcircuit, répondant mieux que ceux antérieurement connus aux exigences de la pratique, notamment en ce qu'il présente une dimension en plan qui ne dépasse pas celle du microcircuit nu et en ce qu'il autorise le test du microcircuit avant montage sur un substrat.

Dans ce but, l'invention propose notamment un boîtier à microcircuit intégré monolithique conforme à la revendication 1.

Un tel boîtier présente le même encombrement que le microcircuit. Le microcircuit du boîtier peut être testé par des moyens classiques (carte à pointes, brasage temporaire à faible résistance, etc...) s'appuyant sur les protubérances. Le boîtier constitue un composant manipulable, adapté au montage automatique et à la fixation par brasage collectif par refusion en phase vapeur. L'encapsulation plastique étanche permet de monter les boîtiers dans des boîtiers externes non hermétiques, sur des substrats brasables.

La plaquette adaptatrice sera généralement en silicium, de façon à avoir le même coefficient de dilatation que le microcircuit et à éviter des contraintes thermomécaniques dans les pièces assemblées lors des variations de températures. Le silicium a par ailleurs un coefficient de dilatation thermique proche de celui des substrats céramiques qui seront généralement utilisés.

Dans la majeure partie des cas, la plaquette adaptatrice a un rôle purement passif de liaison. Toutefois, des éléments passifs tels que des condensateurs ou des résistances peuvent être implantés dans le silicium d'une plaquette adaptatrice. Il est même envisageable d'intégrer des fonctions actives simples, telles que des mémoires tampon ou "buffers", dans le silicium.

L'invention propose également un procédé de montage de microcircuits, faisant intervenir un boîtier du genre ci-dessus défini à titre de produit intermédiaire, conforme à la revendication 6.

On obtient ainsi une puce ayant des connexions réparties en surface, ayant un écartement qui peut être plus élevé que celui des plages d'accueil, car elles sont placées suivant un réseau à deux dimensions. Les plages du microcircuit et les fils sont protégés par l'enrobage. Le montage final sur un substrat peut alors s'effectuer par l'un quelconque des procédés connus d'assemblage par réseau de billes fusibles.

Les caractéristiques ci-dessus ainsi que d'autres apparaîtront mieux à la lecture de la description qui suit d'un mode particulier de réalisation, donné à titre d'exemple non limitatif. La description se réfère aux dessins qui l'accompagnent, dans lesquels :
- la figure 1 est une vue en plan schématique, montrant une puce nue sur laquelle est reportée une plaquette adaptatrice, à l'issue d'une première étape de fabrication d'un boîtier ;
- la figure 2 est une vue en coupe schématique, montrant le produit obtenu à l'issue de la première étape ;
- les figures 3, 4, 5 et 6 montrent des étapes ultérieures de fabrication.

Le procédé qui va être décrit permet de constituer un boîtier à microcircuit, applicable à tout microcircuit monolithique à très haute intégration, dont les dimensions dépassent généralement 8 x 8 mm, ayant des plages de sortie situées à la périphérie d'une face active. Ce cas est celui de la plupart des microcircuits ou "puces" numériques. C'est notamment le cas de beaucoup de microcircuits utilisés dans les équipements spatiaux, ou l'impossibilité de réparer une carte une fois un satellite à poste rend une fiabilité élevée à long terme indispensable.

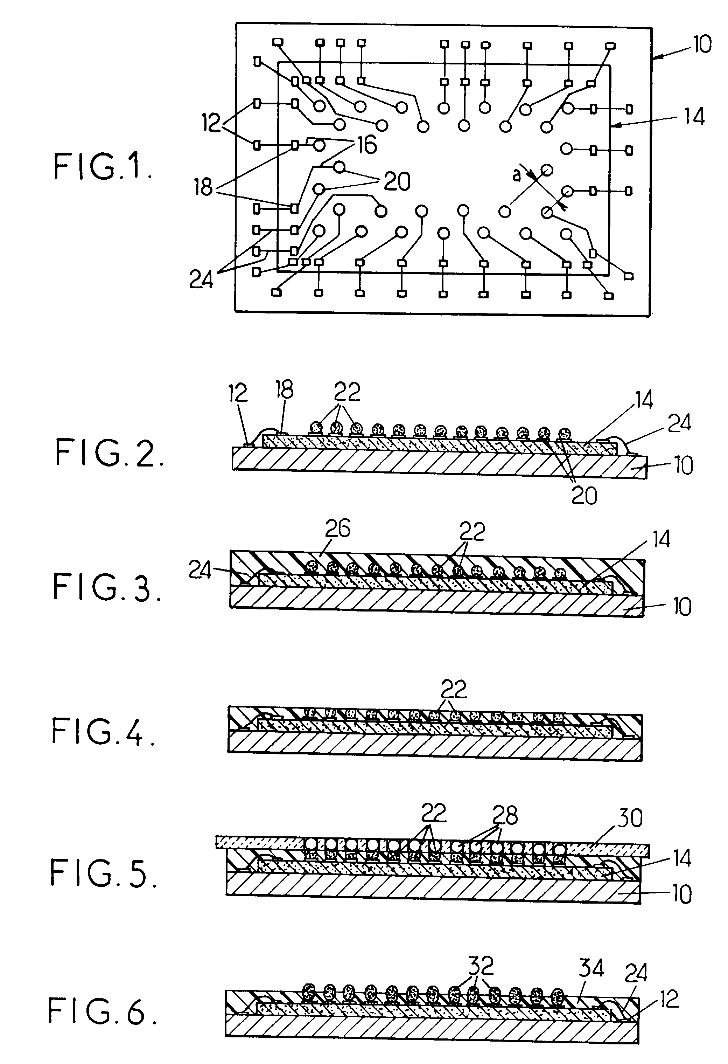

La figure 1 montre la forme générale d'un microcircuit 10, qu'on désignera par la suite par le terme usuel de puce. Une face active de la puce est munie de plages de sortie 12 réparties à sa périphérie, à proximité du bord. Sur la face active est collée une plaquette adaptatrice 14, généralement en silicium, de dimensions plus faibles que la puce 10 de façon à laisser libre le périmètre occupé par les plages de sortie. La plaquette est collée sur la puce à l'aide d'une colle isolante d'usage classique en microélectronique hybride. On peut notamment utiliser des préformes constituées par une pellicule sèche.

La plaquette adaptatrice 14 est, avant collage, munie d'un réseau de pistes conductrices 16, généralement en aluminium, obtenues par un procédé usuel dans la fabrication des circuits intégrés actifs. Chaque piste 16 relie une plage d'accueil 18 située à proximité d'une plage de sortie respective 12 à une plage de soudage 20. Chaque piste 16 constitue ainsi une liaison équipotentielle entre une plage d'accueil et une plage de soudage. Alors que les plages d'accueil seront généralement réparties suivant une seule ligne, les plages de soudage peuvent être disposées suivant un réseau à deux dimensions. Dans le cas illustré sur la figure 1, les plages de soudage sont disposées suivant deux rectangles concentriques. Grâce à cette disposition, chaque plage de soudage 20 peut avoir une dimension plus importante que la plage d'accueil correspondante et l'espacement entre les plages de soudage 20 peut être nettement supérieur à l'écartement entre les plages d'accueil (et les plages de sortie correspondantes).

Dans la pratique, le procédé sera souvent mis en oeuvre sur des puces ayant un écartement entre plages de sortie supérieur à 100 µm. Avec la disposition représentée sur la figure 1, l'espacement entre plages de soudage pourra alors dépasser 350 µm. En pratique, on recherchera généralement un écartement à environ 0,5 mm.

Sur la face opposée à celle qui est collée à la puce 10, la plaquette intermédiaire 14 est équipée de microbilles métalliques 22, en matériau fusible, (alliage étain-plomb en général) ou non fusible (par exemple en cuivre, nickel ou alliage brasable). Le matériau qui les constitue doit être mouillable par un alliage d'étain, lors d'une étape ultérieure. Lorsque la tenue à long terme est essentielle, les plages 20 sont revêtues en surface d'une pellicule constituant barrière métallurgique, destinée à éviter une dégradation dans le temps de la liaison.

Une fois la plaquette adaptatrice collée, on relie les plages de sortie 12 aux plages d'accueil 18 par des tronçons de fils d'aluminium ou d'or, généralement d'environ 25 µm de diamètre. Les extrémités de chaque tronçon peuvent être fixées sur les plages à l'aide d'une sonotrode. La saillie des microbilles 22 au-dessus de la plaquette doit être supérieure, généralement au moins deux fois supérieure, à la saillie des coudes des tronçons de fils 24 pour permettre l'abrasion ultérieure partielle des microbilles, comme on le verra plus loin.

Au cours de l'étape suivante du procédé, on surmoule la face équipée de la puce 10 et la plaquette 14. Comme le montre la figure 3, l'épaisseur de résine de surmoulage 26 est suffisante pour noyer les tronçons de fils 24 et les microbilles 22. Les dimensions en plan du surmoulage sont les mêmes que celles de la puce 10, de sorte que l'encombrement du boîtier final ne dépassera pas celui de la puce.

Au cours de l'étape suivante (figure 4), on attaque par abrasion le surmoulage, parallèlement au dos de la puce qui sert de plan de référence. L'attaque est effectuée sur une profondeur telle que les microbilles 22 apparaissent. Pratiquement, on enlèvera une profondeur de bille 22 comprise entre un demi-rayon et un rayon.

Au cours de l'étape suivante, on dépose une microbille additionnelle 28 en alliage fusible sur chaque microbille 22. Cette opération peut être effectuée par dépôt à travers les trous d'un outil 30 tel qu'une plaque fine de céramique, percée de trous fins au laser (figure 5). On porte ensuite l'ensemble en étuve pour refondre collectivement les microbilles. On constitue ainsi des protubérances 32 de forme oblongue, qui dépassent de l'enrobage subsistant 34 (figure 6). On obtient ainsi une puce équipée, constituant pratiquement un boîtier, dont les connexions sont facilitées par les dimensions et l'écartement des plages de soudage 20. L'enrobage en résine protège les plages de sortie 12 de la puce et les fils 24.

Si nécessaire, le boîtier peut être complété par dépôt d'une couche mince d'un matériau imperméable, tel que la silice ou le Parylène. Pour permettre ultérieurement les connexions, il suffit d'un léger rodage des protubérances 32 qui met le métal à vif en vue du report sur un substrat.

L'invention est susceptible de nombreuses variantes de réalisation. Les plages de soudage 20 peuvent être disposées sur un nombre de rangées concentriques supérieures à deux, bien qu'il soit généralement souhaitable de les disposer le plus près possible de la périphérie. Les pistes conductrices 16 peuvent être prévues dans une plaquette multicouche pour permettre des croisements entre pistes. Lorsque des puces d'épaisseurs différentes doivent être montées sur un même substrat et qu'il est souhaitable de donner à l'ensemble plaquette-puce la même épaisseur pour tous les boîtiers, l'épaisseur de certaines plaquettes peut être réduite par abrasion pour les adapter aux puces les plus épaisses.

## Revendications

1. Boîtier à microcircuit intégré monolithique, comprenant :
un microcircuit (10) présentant des plages de sortie (12) réparties à la périphérie d'une face active,
une plaquette adaptatrice (14) dont une face est collée à la face active, laissant libres les plages de sortie (12), présentant à sa périphérie des plages d'accueil (18) reliées chacune par une piste équipotentielle (16) à une protubérance (32) en saillie sur la face opposée à la face collée,
des fils métalliques (24) soudés de liaison entre les plages de sortie (12) et les plages d'accueil (18) et
un enrobage étanche (34) à dans lequel sont noyés les fils et à travers lequel font saillie les protubérances.

2. Boîtier selon la revendication 1, caractérisé en ce que la plaquette adaptatrice est en silicium, mono ou multicouches.

3. Boîtier selon la revendication 1, caractérisé en ce que la plaquette adaptatrice est en silicium dans lequel sont implantés des éléments passifs.

4. Boîtier selon la revendication 1, 2 ou 3, caractérisé en ce que les protubérances sont réparties en plusieurs rangées, et ont un écartement mutuel supérieur à celui des plages d'accueil.

5. Boîtier selon l'une quelconque des revendications précédentes, caractérisé en ce que les protubérances sont en alliage fusible, au moins dans leur partie en saillie.

6. Procédé de montage sur un substrat de microcircuit intégré monolithique présentant des plages de sortie réparties à la périphérie d'une face active, suivant lequel :
on constitue une plaquette adaptatrice (14) de dimensions en plan inférieures à celle du microcircuit de façon à laisser libres les plages de sortie, présentant à sa périphérie des plages d'accueil (18) reliées chacune par une piste équipotentielle métallique (16) à une plage de soudage équipée chacune d'une microbille (22),
on colle la plaquette sur la face active du microcircuit,
on relie les plages d'accueil (18) aux plages de sortie (12) par soudage de tronçons de fil, la saillie des fils étant inférieure à celle des microbilles (22),
on surmoule un enrobage plastique (26) sur la face active du microcircuit, la plaquette et les microbilles,
on abrase le surmoulage pour mettre à nu les microbilles (22), et
on dépose une bille supplémentaire (28) en alliage fusible sur chaque microbille abrasée et
on constitue des protubérances dépassant de l'enrobage par refusion collective de l'ensemble des microbilles.

7. Procédé selon la revendication 6, caractérisé en ce que la saillie des microbilles (22) est au moins double de celle des tronçons de fil.

8. Procédé selon la revendication 7, caractérisé en ce qu'on abrase le surmoulage et les microbilles sur une profondeur de ces microbilles comprise entre un demi-rayon et un rayon.

9. Procédé selon la revendication 6 ou 7, caractérisé en ce que les microbilles (22) sont en alliage fusible de soudage, en cuivre, en nickel ou en alliage brasable non fusible.

10. Procédé selon la revendication 6, 7 ou 8, caractérisé en ce que les billes supplémentaires sont en alliage fusible de soudage et déposées à travers les trous d'une plaque de céramique.
